Europäisches Patentamt

European Patent Office

Office européen des brevets

(19)

(11) Publication number: **0 055 318**
**B1**

## EUROPEAN PATENT SPECIFICATION

(45) Date of publication of patent specification: **23.10.85**

(51) Int. Cl.⁴: **C 30 B 11/00,** C 30 B 29/06

(21) Application number: **80304786.9**

(22) Date of filing: **31.12.80**

(54) Method of producing semicrystalline silicon and products formed thereby.

(43) Date of publication of application:
**07.07.82 Bulletin 82/27**

(45) Publication of the grant of the patent:
**23.10.85 Bulletin 85/43**

(84) Designated Contracting States:
**AT BE CH DE GB IT LI LU NL SE**

(56) References cited:
FR-A-1 475 991
FR-A-2 302 132

IBM JOURNAL OF RESEARCH AND
DEVELOPMENT, vol. 23, no. 3, May 1979 New
York, US T.F. CISZEK et al.: "Solar-Grade
Silicon by Directional Solidification in Carbon
Crucibles", pages 270-277

(73) Proprietor: **Solarex Corporation**
**1335 Piccard Drive**
**Rockville Maryland 20850 (US)**

(72) Inventor: **Lindmayer, Joseph**
**6919 Blaisdell Road**
**Bethesda Maryland (US)**

(74) Representative: **Spencer, Graham Easdale et al**
**A.A. Thornton & CO Northumberland House**
**303-306, High Holborn**
**London WC1V 7LE (GB)**

EP 0 055 318 B1

## Description

The present invention is concerned with a method of producing a silicon product suitable for use in certain semi-conductor devices. More specifically, it is concerned with a method whereby semicrystalline silicon, that is silicon having a grainy structure, is obtained, this product being suitable for use, for example, in making silicon solar energy cells, although it is not in the form of the single crystal silicon normally used for such purpose.

Hitherto, so-called single crystal or semi-conductor grade silicon has been used to make silicon solar energy cells. The cost of such crystalline silicon in ingot form is presently about $300/kg, the preponderant proportion of which is due to the expense of forming the crystalline structure of the silicon. Single crystal silicon is typically produced by either the Czochralski (CZ) or Float Zone (FZ) method. In the CZ method, molten silicon is seeded and the seeded silicon is then extended by a crystal pulling machine. In the FZ process, zones of a silicon ingot are melted by passing the ingot back and forth through a localized heater. Because these methods are difficult to operate and expensive, the cost of making single crystal silicon is expensive and this causes silicon solar cells to be expensive.

The present invention, on the contrary, is based on the discovery that it is not necessary to use single crystal silicon in making solar cells and that quite satisfactory efficiencies can be obtained with silicon of a high degree of crystallographic order in the form of relatively large grains of crystallites.

At a workshop conference conducted at Cherry Hill, New Jersey, U.S.A. on October 23rd to 25th, 1973, which conference was sponsored by the National Science Foundation, a workshop was devoted to the subject of polycrystalline silicon. An executive report on the workshop conference is dated October 15th 1974. The chairman of the polycrystalline silicon workshop was Dr. T. L. Chu, of Southern Methodist University. At that workshop, as reported in Volume 1 of the Proceedings thereof, the major problems of using polycrystalline silicon were outlined. At that time it was recognized that technological breakthrough would be necessary in order to overcome the known low efficiencies of solar energy cells formed from polycrystalline silicon. As an objective, the first goal set forth in the proceedings of the workshop was to produce a polycrystalline silicon solar cell with a 5% efficiency. It was an objective to produce such a photovoltaic cell in five years, that is by 1978, and a 10% efficient cell by 1983. The 10% efficient cell objective has now been accomplished and the method for obtaining a silicon for that cell is the subject of the present invention.

The present invention is based on our discovery that molten silicon, regardless of the original crystallographic structure thereof, can give rise, on solidification, to silicon of much more desirable crystallographic structure, the product being what we believe is most properly termed semicrystalline silicon. While, as evidenced by the title of the NSF Polycrystalline Silicon Workshop in 1973, silicon that is crystalline and in a form other than single crystal has been termed polycrystalline, it is believed that the term, semicrystalline, is more appropriate to describe silicon in which the grain size is in the order of millimetres. According to our experimentation, it is not simply the number of crystal centres that are formed in a crystalline silicon material that controls the suitability of the silicon for use in making photovoltaic cells. It is, *inter alia*, the presence of highly ordered crystalline silicon, regardless of the fact that the crystalline silicon may be enclosed or separated by regions of less well ordered crystalline silicon. Stated otherwise, semicrystalline silicon is that where a high degree of order exists within the grains and defects can be assigned to the grain boundaries.

By the practice of the present invention, it has been found possible to produce a silicon ingot and wafers that have a plurality of crystal centres, but which, at the same time, have crystal grains of a size sufficient to have most defects concentrated at the grain boundaries. Other than at grain boundaries, the grains are highly ordered so far as crystallographic structure is concerned.

According to the present invention, there is provided a method of producing a doped semicrystalline silicon body suitable for use in photovoltaic cells, which comprises

(a) heating silicon of indiscriminate grain size and a dopant therefor of a single conductivity type in a container which is substantially inert at the melting temperature of silicon and under a non-oxidising atmosphere, to a temperature in excess of the melting point of silicon so as to form a mass of molten silicon

(b) gradually cooling the molten mass to its solidification temperature, such cooling taking place over a period of time such that crystal centres are formed at random locations throughout the molten silicon mass,

(c) maintaining the silicon mass within the region of the solidification point of silicon (1412 to 1408°C) for a time sufficient to enlarge the crystallites formed at the crystal centres until they have a mean diameter of at least 1 mm, and

(d) then completing the cooling of the silicon mass to ambient temperature to form a semicrystalline silicon body containing a dopant of a single conductivity and comprising silicon crystallites having a mean diameter of at least 1 mm which are distributed in a random fashion with no fixed pattern to the grain boundaries and with no grain boundaries running from one surface of a wafer cut from the body to the other surface in a straight line.

The gradual cooling at the solidification point of the silicon has been found to accomplish two purposes; (i) it maintains the continuum of the silicon, that is it mitigates the formation of air bubbles and other imperfections and disruptions to the resulting, solid silicon, and (ii) it encourages the formation of silicon of a relatively large grain size, regardless of the original state of the silicon. When the cooling has been carried out in a gradual manner, preferably for at least five minutes and more preferably over a period of 10 to 15 minutes as the temperature of the silicon passes through the region of the solidification point of the silicon (1412° to 1408°C), holes or pockets formed by air trapped in the ingots are substantially eliminated. Moreover, comparatively large crystallites are formed. Consequently, the product of the present process is first an ingot or cast body of silicon and then, after slicing, a silicon wafer that is relatively free of holes and will have at least one surface composed of comparatively large crystallites or grains.

Upon analysis, these grains are found to contain crystallites of silicon. The interiors of the grains are highly ordered with respect to the crystallographic structure of the silicon. By this is meant that the crystalline silicon near the central region of each grain is quite similar to single crystal silicon in structure. At peripheral portions of the individual grains, however, which peripheral portions are referred to herein as grain boundaries, there is a relatively high concentration of defects in the crystal structure. The grain boundaries, it is found, are composed of what might be termed poorly ordered silicon in combination with impurities. Consequently, while the highly ordered silicon with the silicon grains is suitable for use in photovoltaic cells, it is found that silicon at the grain boundaries, which silicon is relatively disordered, is not nearly as suitable for that use.

Since it is at the grain boundaries that impurities are concentrated and at which the crystallographic state of the silicon is relatively disordered, it has become apparent that there is a definite relationship between grain size and solar cell efficiency. For the background of the so-called diamond structure of silicon crystals, see *Fundamentals of Semiconductor Devices*, by Joseph Lindmayer and Charles Y Wrigley, D. Van Nostrand and Co., Inc., Princeton, N.J. (1965), Chapter 6. In general, the efficiency of a silicon device for converting solar energy into electricity varies in accordance with the grain or crystallite size, that is the larger the grain, the greater the solar cell efficiency. Over certain ranges of grain size, those quantities vary directly and in a straight-line ratio.

Regarding multiple grains of silicon as manifestations of high densities of defect states of the silicon as compared to single crystals, it is possible to calculate solar conversion efficiencies as a function of crystal defect density. Such a plot shows that for the semicrystalline silicon produced by practising the present process to have utility in forming silicon wafers for use as photovoltaic devices, the size of the grains of silicon, at least at the surface of the silicon wafer and preferably throughout the entirety of the wafer and ingot, should have a mean diameter of at least 1 mm and preferably of from 1 to 10 mm.

Since the silicon crystallites or grains are not perfect spheres, many will not have true diameters. Consequently, the term diameter is used to mean the longest straight line that can be drawn through the centre of the grain and terminated at opposed surfaces of the grain. With mean diameters of at least 1 mm, it is found that there will be a sufficient quantity of highly ordered crystallographic silicon within the grains to provide photovoltaic results approaching that of single crystal silicon despite the presence of the less ordered silicon and impurities at the grain boundaries.

Further features and advantages of the invention will become apparent from the following description of a preferred embodiment of the method.

The starting material used was refined silicon, which is commonly referred to as "poly". This poly has silicon crystallites of a mean diameter of about eight μm. (Another suitable starting material is metallurgical grade silicon which contains more impurities than poly; if metallurgical grade silicon is used, impurities therein are preferably removed prior to carrying out the method according to the invention).

The refined silicon was placed in a graphite crucible and some elemental boron was added as a dopant so that the resulting silicon, after casting was of the p-type. The crucible was placed in a quartz tube surrounded by radio frequency heating coils. The crucible and the coils were enclosed within a heating chamber, the controls to which, for purposes of safety, were operable from outside the chamber.

Through suitable connections a flow of gas consisting of a mixture of hydrogen and argon in approximately equal proportions was initiated through the tube and about and past the crucible. At the same time, the rf generator was activated and the power increased until the silicon in the chamber was in a molten, that is liquid, state. By the use of an optical pyrometer, the temperature of the molten silicon was adjudged to be about 1450°C.

After the molten silicon had been maintained in that state subjected to inert gas flow, the temperature of the molten silicon was allowed to fall slowly. During cooling, the radio frequency heater was maintained in operation but at a lesser rate of heating than had previously been used to melt the silicon. After about eight minutes, the temperature of the molten silicon had fallen from about 1430°C to approximately 1412°C, when it was apparent that silicon crystals were beginning to form. At that time, the setting of the radio frequency heater was increased slightly. Ten minutes later the temperature of the molten silicon had decreased to 1410°C. The setting of the radio frequency heater was again increased slightly and after a further five minutes the temperature of the silicon in the crucible was approximately 1409°C. The setting of the radio frequency heater was then reduced substantially, and after an additional twenty minutes, the temperature within the chamber and the temperature of the silicon, which had now solidified, was approximately 1250°C. Thereafter all radio frequency heating was stopped and the flow of gas stopped. After an hour or so, the crucible and the solidified silicon were at ambient temperature.

After removal of the solidified silicon from the graphite crucible, it was substantially in the form of an ingot which externally appeared free of punctures. The ingot was sliced into wafers. The silicon wafers were substantially free of holes, although there were some very small holes in some slices. Examination under a microscope showed that the surface of a slice was composed of crystallites of silicon with a mean diameter of about 2 mm. The crystallites varied in size from about 1 mm to about 3 or 4 mm in diameter, and at the surface of the slice were in approximately the same plane, although there were slight variations in outward extension between crystallites at the surface of a slice. Upon further examination, it was observed that the grains or crystallites of silicon extended completely through the slices and that both surfaces of the sliced silicon exhibited substantially the same structure. The grains appeared to be randomly arranged, that is there was no fixed pattern to the grain boundaries, and no grain boundaries ran perpendicularly from one surface of the wafer to the other in a straight line. Instead, the grain boundaries followed a sinuous path from one surface to another, such path being determined by the random arrangement of the silicon crystallites or grains.

The slice was then etched and an impurity of opposite sign to the dopant incorporated in the cast silicon was diffused into the slice. After aluminium had been evaporated on to the back of the wafer to establish a back contact and a front pattern of grids has been applied, the cell was tested for efficiency using a light source equivalent to one full sun. The efficiency of the cell so tested was approximately 10%. The fact that a silicon photovoltaic cell having a 10% efficiency could be made confirms that it is possible to manufacture silicon solar energy cells from an initially polycrystalline silicon, for example refined or metallurgical grade silicon.

As described above, the container for the silicon should be inert, that is there should be substantially no reaction between the container and the silicon. Likewise, the gases passed over and around surface of the molten silicon are inert with respect to the silicon and the container and the atmosphere is non-oxidizing. They are, however, not necessarily inert with respect to impurities in the silicon.

The essential feature of the process according to the invention is the production of silicon crystallites having a sufficient grain size. Such grain size is obtained by gradual cooling of molten silicon, specifically in the region of the solidification or crystallisation point of the silicon. While there is, in general, a direct relationship between grain size and efficiency, it is believed that grains of silicon having a mean diameter of at least 1 mm are required. Much smaller grain sizes, for example, grains having a mean diameter of 8 μm, were found to yield silicon wafers having an efficiency of about 0.5%; such wafers are most certainly unsuitable for use in photovoltaic cells.

## Claims

1. A method of producing a doped semicrystalline silicon body suitable for use in photovoltaic cells, which comprises
   (a) heating silicon of indiscriminate grain size and a dopant therefor of a single conductivity type in a container which is substantially inert at the melting temperature of silicon and under a non-oxidizing atmosphere, to a temperature in excess of the melting point of silicon so as to form a mass of molten silicon,
   (b) gradually cooling the molten mass to its solidification temperature, such cooling taking place over a period of time such that crystal centres are formed at random locations throughout the molten silicon mass,
   (c) maintaining the silicon mass within the region of the solidification point of silicon (1412 to 1408°C) for a time sufficient to enlarge the crystallites formed at the crystal centres until they have a mean diameter of at least 1 mm, and
   (d) then completing the cooling of the silicon mass to ambient temperature to form a semicrystalline silicon body containing a dopant of a single conductivity and comprising silicon crystallites having a means diameter of at least 1 mm which are distributed in a random fashion with no fixed pattern to the grain boundaries and with no grain boundaries running from one surface of a wafer cut from the body to the other surface in a straight line.

2. A method according to claim 1, in which the silicon mass is maintained substantially at the solidification temperature for at least five minutes.

3. A method according to claim 1 or 2, in which the silicon mass is maintained substantially at the solidification temperature for 10 to 15 minutes.

4. A method according to any of claims 1 to 3, in which the silicon mass is maintained in step (c) at a temperature of from 1412° to 1409°C.

5. A method according to any of claims 1 to 4, in which the heating is effected by a radio frequency generator.

6. A method according to any of claims 1 to 5, in which cooling of the silicon mass at its solidification point is controlled by the use of a radio frequency generator.

7. A semicrystalline silicon wafer composed of randomly arranged silicon grains, the grains at least at one surface of the wafer having a mean diameter of at least 1 mm and abutting each other at the boundaries of the grains, said grains in their interiors being composed of silicon of relatively high crystallographic order when compared with the silicon at the grain boundaries and the grains being distributed in a substantially non-columnar and non-linear fashion in the wafer.

8. A semicrystalline silicon wafer according to claim 7, in which the grains at the surface have a mean diameter of 1 to 10 mm.

9. A silicon ingot composed of randomly arranged grains of semicrystalline silicon, the grains having a mean diameter of at least 1 mm and abutting each other at the boundaries of the grains, said grains in their interiors being composed of silicon of relatively high crystallographic order when compared with the silicon at the grain boundaries and the grains being distributed in a substantially non-columnar and non-linear fashion in the ingot.

10. A silicon ingot as claimed in claim 9, in which substantially all the grains of silicon in central portions of the ingot have a diameter of from 1 to 10 mm.

**Revendications**

1. Procédé d'obtention d'une forme de silicium semi-conducteur cristalline dopée adaptée pour être utilisée dans des cellules photovoltaïques, caractérisé en ce que qu'il comprend:

(a) le chauffage du silicium de granulométrie irrégulière et un agent de dopage pour ce dernier, à simple conductivité, dans un réservoir pratiquement inerte à la température de fusion du silicium et sous une atmosphère non oxydante, jusqu'à une température supérieure au point de fusion du silicium pour former une masse de silicium fondu,

(b) refroidissement progressif de la masse fondue jusqu'à sa température de solidification, un tel refroidissement s'effectuant pendant une durée telle que les centres de cristallisation se forment en des positions aléatoires dans l'ensemble de la masse de silicium fondue,

(c) en maintenant la masse de silicium dans un voisinage du point de solidification du silicium (1408 à 1412°C) pendant une durée suffisante pour développer les cristallites formées aux centres de cristallisation jusqu'à ce qu'elles possèdent un diamètre moyen d'au moins 1 mm, et

(d) puis en finissant le refroidissement de la masse de silicium à la température ambiante pour former un silicium semi-cristallin contenant un agent de dopage à simple conductivité et comprenant des cristallites de silicium ayant un diamètre moyen d'au moins 1 mm qui sont distribuées suivant un mode aléatoire sans plan fixé aux joints des grains et sans joints de grains à partir d'une face d'une tranche de la structure jusqu'à l'autre face en ligne droite.

2. Procédé selon la revendication 1, caractérisé en ce que la masse de silicium est maintenue sensiblement à la température de solidification pendant au moins 5 min.

3. Procédé selon la revendication 1 ou 2, caractérisé en ce que la masse de silicium est maintenue sensiblement à la température de solidification pendant 10 à 15 min.

4. Procédé selon l'une des revendications 1 à 3, caractérisé en ce que la masse de silicium est maintenue à l'étape (c) à une température comprise entre 1409 et 1412°C.

5. Procédé selon l'une des revendications 1 à 4, caractérisé en ce que le chauffage est réalisé au moyen d'un générateur à haute fréquence.

6. Procédé selon l'une des revendications 1 à 5, caractérisé en ce que le refroidissement de la masse de silicium à son point de solidification est contrôlée au moyen d'un générateur à haute fréquence.

7. Tranche de silicium semi-cristallin constituée de grains de silicium arrangés de façon aléatoire, les grains ayant sur au moins une face de la tranche un diamètre moyen d'au moins 1 mm et étant en contact les uns des autres au niveau des joints des grains, lesdits grains étant composés à l'intérieur de silicium à relativement haut degré cristallographique comparé avec le silicium aux joints des grains et les grains étant distribués dans la tranche suivant un mode sensiblement non prismatique et non linéaire.

8. Tranche de silicium semi-cristallin selon la revendication 7, caractérisé en ce que les grains à la surface ont un diamètre moyen de 1 à 10 mm.

9. Lingot de silicium constitué de grains arrangés de façon aléatoire de silicium semi-cristallin, les grains ayant un diamètre moyen d'au moins 1 mm et étant en contact les uns des autres aux joints des grains, lesdits grains étant constitués à l'intérieur de silicium de relativement haut degré cristallographique comparé avec le silicium des joints des grains et les grains étant distribués dans le lingot suivant un mode sensiblement non prismatique et non linéaire.

10. Lingot de silicium selon la revendication 9, caractérisé en ce que pratiquement tous les grains de silicium dans les parties centrales du lingot ont un diamètre allant de 1 à 10 mm.

**Patentansprüche**

1. Verfahren zur Herstellung eines angereicherten halbkristallinen Silikonkörpers, der zur Verwendung in Photoelementen geeignet ist, wobei das Verfahren die Schritte umfaßt:

a) die Aufheizung von Silikon einer wahllosen Korngröße und eines dafür vorgesehenen Dotierungsmittels eines bestimmten Leitfähigkeitstyps in einem Behälter, der bei der Schmelztemperatur von Silikon im wesentlichen keine Reaktionen eingeht und in einer nicht oxidierenden Atmosphäre auf eine Temperatur, die über dem Schmelzpunkt von Silikon liegt, um so eine Silikonschmelzmasse zu erzeugen,

b) das allmähliche Abkühlen der Schmelzmasse auf die Erstarrungstemperatur, wobei die Abkühlung über einen solchen Zeitraum durchgeführt wird, daß sich an willkürlichen Stellen innerhalb der geschmolzenen Silikonmasse Kristallisationszentren bilden,

c) die Aufrechterhaltung der Silikonmasse auf einer Temperatur innerhalb eines Bereiches um den Erstarrungspunkt des Silikons (1412—1408°C) über eine Zeit, die dazu ausreicht, daß die um die Kristallzentren wachsenden Kristalle so weit angewachsen sind, daß sie einen Hauptdurchmesser von wenigstens 1 mm haben und

d) Fortsetzung der Abkühlung der Silikonmasse auf die Umgebungstemperatur, um einen halbkristallinen Silikonkörper zu erzeugen, der ein Dotierungsmittel eines bestimmten Leitfähigkeitstyps beinhaltet und der Silikonkristalle besitzt, die einen Hauptdurchmesser von wenigstens 1 mm haben, und die willkürlich verteilt vorliegen, ohne eine bestimmte feststehende Ausrichtung der Korngrenzen und ohne Korngrenzen, die bei einer Wafer, die von dem Körper abgeschnitten wird, von einer Oberfläche zu der anderen Oberfläche in einer geraden Linie verlaufen würde.

2. Verfahren nach Anspruch 1, wobei die Silikonmasse über wenigstens 5 Minuten im wesentlichen auf der Erstarrungstemperatur gehalten wird.

3. Verfahren nach Anspruch 1 oder 2, wobei die Silikonmasse über 10 bis 15 Minuten im wesentlichen auf der Erstarrungstemperatur gehalten wird.

4. Verfahren nach irgend einem der Ansprüche 1 bis 3, bei dem die Silikonmasse im Schritt (c) auf einer Temperatur von 1412° bis 1409°C gehalten wird.

5. Verfahren nach irgend einem der Ansprüche 1 bis 4, bei dem das Aufheizen mit einem Radiofrequenzgenerator bewirkt wird.

6. Verfahren nach irgend einem der Ansprüche 1 bis 5, bei dem das Abkühlen der Silikonmasse auf den Erstarrungspunkt unter Verwendung eines Radiofrequenzgenerators gesteuert wird.

7. Halbkristalline Silikonwafer bestehend aus zufällig angeordneten Silikonkörnern, wobei die Körner an wenigstens einer Oberfläche der Wafer einen Hauptdurchmesser von wenigstens 1 mm haben und an den Kornrändern aneinander anstoßen, wobei die Körrner im Inneren aus Silikon relativ hoher kristallinischer Ordnung im Vergleich mit dem Silikon an den Korngrenzen besteht und wobei die Körner in einer im wesentlichen nicht ausgerichteten und nicht linearen Art und Weise in der Wafer verteilt sind.

8. Halbkristalline Silikonwafer nach Anspruch 7, wobei die Körner an der Oberfläche einen Hauptdurchmesser von 1 bis 10 mm haben.

9. Silikonrohblock, bestehend aus zufällig angeordneten Körnern aus halbkristallinem Silikon, wobei die Körner einen Hauptdurchmesser von wenigstens 1 mm haben und an den Korngrenzen aneinander anstoßen, wobei die Körner im Inneren aus Silikon einer relativ hohen kristallinischen Ordnung verglichen mit dem Silikon an den Korngranzen bestehen und wobei die Körner in einer im wesentlichen nicht ausgerichteten und nicht linearen Art und Weise in dem Rohblock verteilt sind.

10. Silikonrohblock nach Anspruch 9, wobei im wesentlichen alle Silikonkörner in mittleren Bereichen des Rohblocks einen Durchmesser von 1—10 mm haben.